# FASCICULE DE BREVET EUROPEEN

(11) **EP 3 325 696 B1**
(45) Date de publication et mention de la délivrance du brevet: **22.05.2019**
(21) Numéro de dépôt: 16741579.3
(22) Date de dépôt: 12.07.2016
(51) Int. Cl.: C30B 25/04, C30B 25/20, C30B 29/04

(54) **ELIMINATION DES DISLOCATIONS DANS UN MONOCRISTAL**
BESEITIGUNG VON VERSETZUNGEN BEI EINEM EINKRISTALL
ELIMINATING THE DISLOCATIONS IN A SINGLE CRYSTAL

(30) Priorité: 17.07.2015 FR 1556770
(43) Date de publication de la demande: 30.05.2018
(73) Titulaire: UNIVERSITE PARIS 13 PARIS NORD, 93430 Villetaneuse (FR); Centre National de la Recherche Scientifique CNRS, 75794 Paris Cedex 16 (FR)
(72) Inventeur: TALLAIRE, Alexandre, 93800 Epinay-sur-Seine (FR); GICQUEL PRADEL, Alix, 75016 Paris (FR); MILLE, Vianney, 95170 Deuil La Barre (FR); BRINZA, Ovidiu, 95170 Deuil La Barre (FR); ACHARD, Jocelyn, 95120 Ermont (FR)
(74) Mandataire: Cabinet Novitech
(86) Numéro de dépôt international: PCT/EP2016/066534
(87) Numéro de publication internationale: WO 2017/012925

(56) Documents cités:
- FR-A1- 2 995 618
- JP-A- 2013 053 050
- US-A1- 2007 218 660
- US-A1- 2009 127 506

## Description

### DOMAINE DE L'INVENTION

La présente invention concerne un substrat germe de diamant monocristallin, pour la croissance homoépitaxiale de diamant par dépôt chimique en phase vapeur ainsi qu'un procédé de formation d'un monocristal de diamant. En outre, l'invention se rapporte à un substrat germe de diamant monocristallin obtenu par un procédé selon l'invention.

### ETAT DE LA TECHNIQUE

Le développement de monocristaux de matériaux semiconducteurs de très haute pureté et de très haute qualité cristalline connait depuis plusieurs années un intérêt grandissant.

En effet, ces monocristaux peuvent être utilisés pour la fabrication de composants électroniques de puissance, de détecteurs de rayonnements de forte énergie, de monochromateurs pour les rayonnements X synchrotron, de dispositifs optoélectroniques, optomécaniques, de dispositifs photoniques et de dispositifs électroniques performants.

Cependant, ces monocristaux peuvent présenter des impuretés et des dislocations qui limitent les performances des composants obtenus.

Une dislocation est un défaut bi-dimensionnel étendu correspondant à une discontinuité dans l'empilement parfait du réseau cristallin, c'est à dire à une déformation plastique du cristal.

Bien que le déplacement induit ne concerne qu'un nombre très réduit d'atomes, l'implication à l'échelle macroscopique sur les propriétés du cristal est généralement très importante.

L'identification et la réduction de la présence de ces défauts dans les monocristaux de matériaux semiconducteurs font l'objet d'intenses recherches. Ainsi c'est essentiellement l'amélioration de la qualité cristalline du carbure de silicium (SiC) obtenue par la suppression de défauts étendus tels que les « micropipes » qui a permis la pénétration de ce matériau dans des applications d'électronique de puissance en remplacement des composants classiques à base de Si. De même, la fabrication de diodes laser à base de nitrures (GaN-AlGaN) n'a été possible qu'au prix d'une forte réduction de la densité de dislocations dans ces matériaux.

Le diamant synthétisé par dépôt chimique en phase vapeur assisté par plasma (PACVD) n'est pas exempt de ce type de problèmes puisque des densités de dislocations de l'ordre de 10⁴ à 10⁷ cm⁻² y sont généralement mesurées. La densité de dislocations est définie comme le nombre de dislocations unitaires présentes par unité de surface du cristal. En effet celles-ci étant généralement « traversantes » le long de la direction de croissance du cristal (« threading dislocations »), elles tendent à émerger à la surface où elles peuvent être facilement dénombrées après révélation par des traitements adaptés.

Les dislocations sont souvent à l'origine d'une biréfringence non désirée qui peut fortement compromettre l'utilisation du matériau pour des applications optiques.

A certaines concentrations extrêmes, il est suspecté que les dislocations soient aussi responsables de la coloration brune des cristaux, peut-être en association avec des lacunes.

Enfin certains types de dislocations peuvent créer des niveaux d'énergie dans la bande interdite du diamant, modifiant les propriétés électroniques du matériau et créant par exemple des courants de fuite dans les diodes de puissance.

La présence de ces dislocations constitue à l'heure actuelle une limitation importante de ce matériau pour de nombreuses applications à forte valeur ajoutée.

La qualité d'un monocristal obtenu par dépôt chimique en phase vapeur est dépendante de la qualité du substrat utilisé comme germe. En effet, le substrat peut contenir des dislocations qui se propagent dans le monocristal lors de sa croissance.

Il est proposé dans JP2013053050 l'utilisation de tranchées avec une ouverture de l'ordre du micron pour diminuer la densité de dislocations lors de l'homoépitaxie.

L'utilisation de substrats de très haute qualité obtenus par des techniques Haute Pression Haute Température (HPHT), ne contenant pratiquement pas de dislocations, pourrait permettre de produire des monocristaux de très haute qualité.

En effet, si le polissage et le traitement de la surface de départ est effectué correctement, il a été montré qu'il est possible de fortement limiter la génération de nouvelles dislocations dans la couche de diamant CVD homoépitaxiée et de conserver une faible densité de défauts.

Néanmoins, la disponibilité extrêmement réduite (2 ou 3 sociétés ou laboratoires dans le monde étant capables de les produire), la faible taille (quelques mm²) et le coût exorbitant (plusieurs milliers d'euros par échantillon) de tels substrats limitent fortement à l'heure actuelle leur utilisation à grande échelle pour la croissance CVD.

Il existe donc un besoin pour une solution permettant d'obtenir un monocristal de diamant par dépôt chimique en phase vapeur de très haute qualité cristalline et de haute pureté, ayant de grandes dimensions, en initiant la croissance sur un germe de qualité modérée mais dont la disponibilité est grande et le coût réduit.

### EXPOSE DE L'INVENTION

Un but de l'invention est de proposer un substrat germe de diamant monocristallin pour la croissance homoépitaxiale de diamant par dépôt chimique en phase vapeur, permettant d'obtenir un monocristal de diamant de très haute qualité cristalline et de haute pureté et présentant une densité de dislocations inférieure à celle du substrat germe, tout en ayant des grandes dimensions.

L'invention propose ainsi un substrat germe de diamant monocristallin, pour la croissance homoépitaxiale de diamant par dépôt chimique en phase vapeur, présentant un corps comme défini dans la revendication 1.

Le corps forme un bloc massif que l'on vient évider pour venir ensuite réaliser la croissance latérale dans le trou réalisé.

En d'autres termes, l'invention repose sur la mise en forme d'un substrat germe de manière à créer une large ouverture en son centre suivi de la croissance homoépitaxiale sur ce germe en vue de favoriser la croissance latérale et la disparition de cette ouverture. Dans les monocristaux synthétiques, les défauts étendus (en particulier les dislocations traversantes) se propagent en effet généralement selon des directions cristallines privilégiées afin de minimiser leur énergie et leur longueur. Le plus souvent ces directions sont perpendiculaires à la surface initiale du substrat conduisant à un réseau dense de dislocations ce qui se traduit par une détérioration des propriétés du cristal. La présente technique vise à promouvoir une croissance dans une direction pour laquelle la propagation des dislocations est fortement inhibée dans une ouverture traversante la plus large possible.

Les inventeurs ont constaté que le fait d'avoir une ouverture traversante (débouchante) entre la ou les parois supérieures et la paroi inférieure d'un substrat germe de qualité cristalline moyenne ou standard, permet d'obtenir un monocristal de diamant par dépôt chimique en phase vapeur ayant une zone présentant une concentration fortement réduite en dislocations et une haute qualité cristalline. La zone du monocristal de diamant ayant une concentration fortement réduite en dislocation correspond à la zone du monocristal obtenue après croissance et coalescence et se situant au-dessus de l'ouverture traversante du substrat germe.

Le substrat germe de diamant monocristallin selon l'invention peut également comprendre une ou plusieurs des caractéristiques ci-dessous, considérées individuellement ou selon toutes les combinaisons techniquement possibles :
- la (ou les) paroi(s) intérieure(s) est (sont) réalisée(s) pour être verticale(s) quand la paroi inférieure repose en appui sur une base ou un porte-substrat de réacteur ; et/ou
- l'ouverture présente au moins deux parois intérieures, en regard, parallèles l'une à l'autre ; et/ou
- l'ouverture présente un pourtour rectangulaire, et deux paires de deux parois intérieures, en regard, parallèles l'une à l'autre ; et/ou
- la ou les parois supérieures extérieures sont un plan (001) ou équivalent ; et/ou
- les parois intérieures sont orientées entre les plans (100) et (010) ; et/ou
- les parois intérieures sont orientées perpendiculaires à la paroi supérieure définissant ainsi des plans cristallins quelconques ou (100) et équivalent, ou (110) ou équivalent ; et/ou
- la largeur et la longueur de l'ouverture vont de 1 à plusieurs mm ; et/ou
- l'ouverture est réalisée par découpe laser ; et/ou
- la ou les parois supérieures extérieures et les parois intérieures forment un angle quelconque inférieur à 90° ; et/ou
- le corps a été réalisé par un procédé HPHT ou CVD, ou en diamant naturel ; et/ou
- le corps est un parallélépipède rectangle, avantageusement un parallélépipède rectangle à base carrée ; et/ou
- les parois intérieures sont désorientées d'un angle inférieur à 10°, par exemple 3°, par rapport aux parois extérieures du corps ; et/ou
- le pourtour de l'ouverture est circulaire ou conique.

L'invention se rapporte également à un procédé de formation d'un monocristal de diamant comprenant les étapes définies dans la revendication 14.

Le procédé selon l'invention peut comprendre également une étape de découpe de la zone coalescée au-dessus de l'ouverture afin d'en extraire un monocristal contenant une faible densité de dislocations et pouvant à nouveau être utilisé pour une croissance homoépitaxiale.

### DESCRIPTION DES FIGURES

D'autres objectifs, caractéristiques et avantages sortiront de la description détaillée qui suit en référence aux dessins donnés à titre illustratif et non limitatif parmi lesquels :
- la figure 1 représente un substrat germe selon l'invention,
- la figure 2 représente une vue de dessus d'un substrat germe selon l'invention,
- la figure 3 représente une vue en coupe d'un substrat germe selon l'invention ;
- la figure 4 sont des images de substrats de diamant HPHT ajourés selon l'invention ;
- Les figures 5a à 5c montrent dans une vue en coupe transverse, les différentes étapes de la croissance du monocristal au cours d'un procédé selon l'invention. Figure 5a : substrat germe ajouré de départ, figure 5b : étape intermédiaire de croissance, figure 5c : étape finale après coalescence. Les dislocations sont représentées par des lignes noires. Le rectangle pointillé central indique la zone d'intérêt à faible densité de dislocations ;
- les figures 6a à 6d sont des images observées en imagerie de cathodoluminescence à 234 nm et à 120K d'un monocristal obtenu par un procédé selon l'invention aux points A, B, C, D représentés sur la figure 5 ;
- Les figures 7a à 7c montrent dans une vue en coupe transverse, les différentes étapes de la croissance du monocristal au cours d'un procédé selon l'invention lorsque la ou les parois supérieures extérieures et la ou les parois intérieures latérales forment un angle α quelconque inférieur à 90° ;

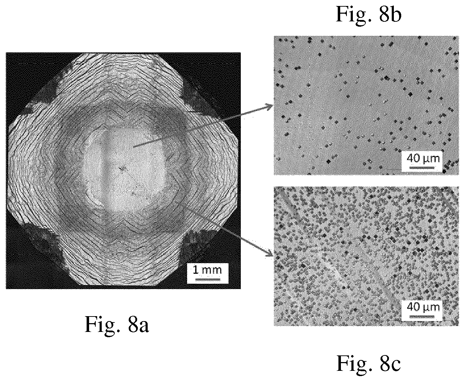

- Les figures 8a à 8c montrent des images en microscopie optique laser de la surface d'un cristal obtenue en utilisant un substrat selon l'invention après révélation des dislocations par un plasma de gravure H2/O2.

### DESCRIPTION DETAILLEE DE L'INVENTION

L'invention repose sur la mise en forme d'un substrat germe de diamant monocristallin pour la croissance homoépitaxiale de diamant par dépôt chimique en phase vapeur.

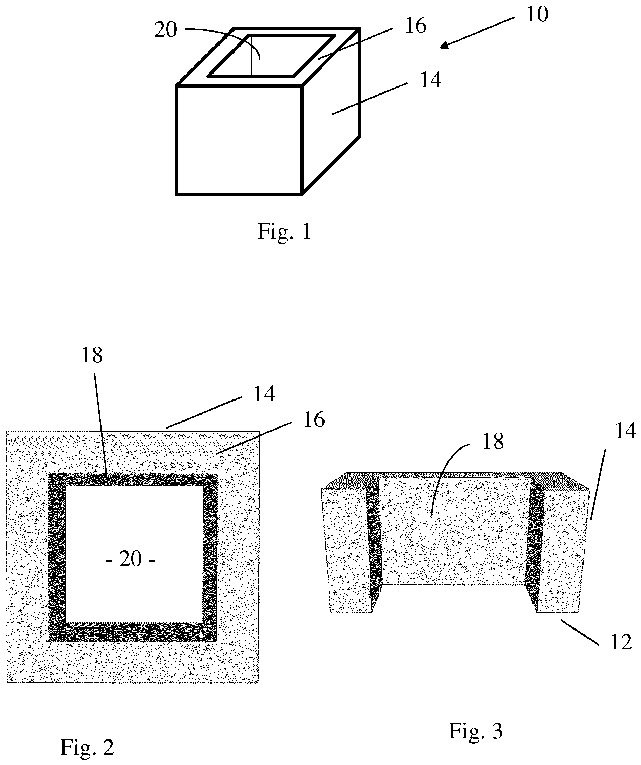

Comme représenté aux figures 1 à 3, le substrat germe présente un corps 10 comprenant :
- une paroi inférieure 12 servant d'appui sur la base ou porte-substrat d'un réacteur,
- une ou de plusieurs parois ou surfaces extérieures latérales 14 destinées à recevoir le dépôt chimique pour la croissance homoépitaxiale, et
- une ou de plusieurs parois ou surfaces extérieures supérieures 16 destinées à recevoir le dépôt chimique pour la croissance homoépitaxiale.

Le corps 10 comprend également une ouverture traversante (ou débouchante) 20 s'étendant de la ou des parois supérieures 16 à la paroi inférieure 12.

L'ouverture traversante 20 délimite ainsi une ou plusieurs parois latérales intérieures 18 sur la ou lesquelles le dépôt chimique pour la croissance homoépitaxiale va également se faire, de façon sensiblement perpendiculaire à ces parois latérales intérieures 18.

Dans les monocristaux synthétiques, les défauts étendus, en particulier les dislocations traversantes, se propagent généralement selon des directions cristallines privilégiées afin de minimiser leur énergie et leur longueur.

Le plus souvent ces directions sont perpendiculaires à la surface initiale du substrat germe conduisant à un réseau dense de dislocations qui se traduit par une détérioration des propriétés du monocristal.

L'ouverture traversante dans le substrat germe selon l'invention vise à promouvoir dans l'ouverture une croissance dans une direction latérale pour laquelle la propagation des dislocations est fortement inhibée.

La croissance s'effectue verticalement à partir des parois supérieures 16 et latéralement à partir des parois intérieures latérales 18. Lorsque la coalescence des fronts de croissance issus des zones latérales et supérieures est effective, la croissance se poursuit verticalement sur l'ensemble de la surface coalescée. Ainsi les dislocations traversantes 16A issues de la face supérieure 16 sont confinées dans le secteur de croissance situé immédiatement au-dessus du substrat. Les dislocations 18A issues des parois intérieures 18 sont confinées latéralement dans l'ouverture du substrat et se terminent sur les surfaces libres intérieures 19 de l'ouverture. A noter que la croissance s'effectue également latéralement à partir des parois extérieures latérales 14.

Le fait que l'ouverture soit traversante permet d'éviter qu'il y ait un fond dans l'ouverture du substrat germe et donc qu'il y ait une croissance normale homoépitaxiale sur ce fond qui viendrait gêner la croissance latérale homoépitaxiale sur les parois intérieures, et propager des dislocations normales dans la croissance de diamant qui a lieu dans l'ouverture traversante.

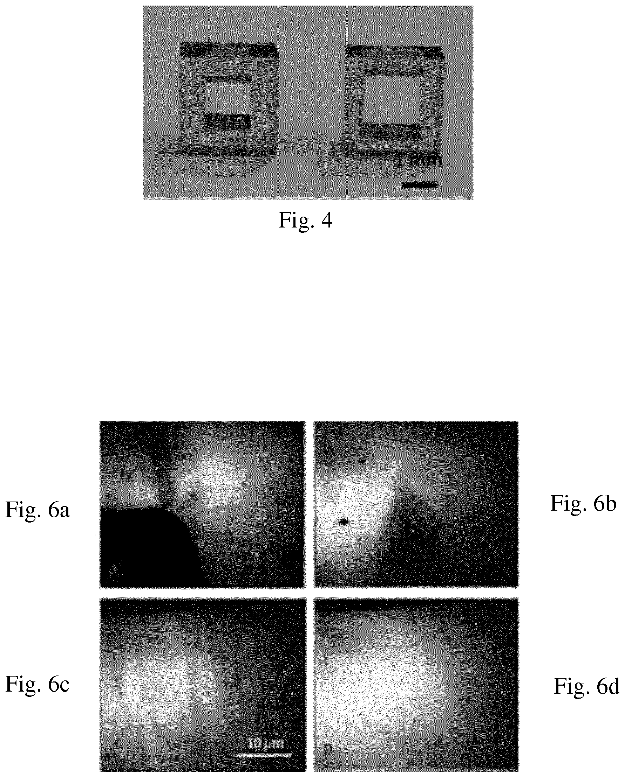

Il en résulte que la zone de monocristal T obtenue après croissance et coalescence dans ou au-dessus de l'ouverture traversante 20 du substrat germe selon l'invention présente une concentration fortement réduite en dislocations. Ceci est confirmé sur les images de cathodoluminescence des figures 6c et 6d, qui montrent respectivement les dislocations présentes dans la zone au-dessus des parois extérieures supérieures 16 et dans la zone T.

Des monocristaux à faible densité de dislocations sont susceptibles de conduire à des propriétés d'usage optimisées pour l'optique ou l'électronique par exemple. Ainsi, l'ouverture traversante présente une hauteur égale à la hauteur du corps, et des dimensions latérales (dans le plan perpendiculaire aux parois intérieures et donc à la hauteur ; qui correspondent à une largeur et une longueur dans le cas d'un pourtour rectangulaire) aussi grandes que possibles, de préférence d'au moins 0,5 mm, par exemple, voire avantageusement de plusieurs millimètres.

L'ouverture traversante 20 doit être la plus grand possible, la taille de la zone T étant directement dépendante de celle de l'ouverture traversante 20.

La dimension latérale de l'ouverture traversante peut donc faire 10 mm, voire plus en fonction de la taille du substrat germe que l'on vient découper avec un laser.

Selon un mode de réalisation de l'invention, le corps du substrat germe est un parallélépipède rectangle. Comme représenté aux figures 1 à 3, le corps peut être un parallélépipède rectangle à base carrée, ou encore un cube.

Dans le cas du diamant synthétisé par dépôt chimique en phase vapeur, une forme particulièrement avantageuse de substrat germe est un monocristal parallélépipède rectangle à base carrée dont toutes les faces sont orientées {100}. Ce type de substrat standard a typiquement mais de façon non limitative une base carrée ayant des longueurs par exemple comprises entre 2 et 9 mm et des hauteurs comprises entre 0,3 et 2 mm.

L'invention s'applique bien entendu à tout type de hauteur du substrat germe, très petite ou très grande, par exemple de 0,3 mm à plusieurs mm.

Le corps d'un substrat germe selon l'invention peut être réalisé par un procédé HPHT ou encore un procédé CVD ou du diamant naturel.

L'ouverture traversante est avantageusement réalisée par découpe laser, ce type de technique de découpe étant bien maitrisé et relativement peu coûteux, et permettant de faire des grandes ouvertures traversantes de façon très précise.

Comme indiqué précédemment, il est préférable que l'ouverture traversante soit la plus grande possible afin de permettre d'obtenir une zone T de monocristal à faible densité de dislocation aussi grande que possible et réalisée au-dessus de cette ouverture traversante 20.

Elle est destinée à évider le corps et est donc située dans le corps sans tenir compte de la localisation des dislocations du substrat germe.

Avantageusement, il est réalisé une seule ouverture traversante la plus grande possible dans le substrat germe, la taille de la zone T étant directement liée à la taille de l'ouverture et sensiblement voisine.

Typiquement, pour un substrat germe selon l'invention obtenue à partir d'un substrat cubique, l'ouverture traversante peut être de forme carrée centrée par rapport aux parois extérieures latérales 14 du substrat, comme représenté sur les figures 1 à 3.

Dans le mode de réalisation des figures 1 à 3, les parois intérieures 18 de l'ouverture traversante carrée présentent la même orientation que celle des parois extérieures latérales 14 du substrat germe. Alternativement, les parois intérieures 18 du contour ou pourtour de l'ouverture traversante carrée peuvent ne pas être parallèles aux parois extérieures latérales 14 et présenter un angle supérieur ou égal à 0,5° et inférieur ou égal à 10° par rapport aux parois extérieures latérales 14 du substrat germe. Alternativement, le pourtour de l'ouverture peut également être circulaire ou conique dans la mesure où la croissance latérale du monocristal de diamant dans l'ouverture peut être obtenue favorablement.

Lorsque le substrat germe selon l'invention est réalisé à partir d'un substrat monocristallin cubique de 3 mm de côté, l'ouverture traversante peut présenter une largeur de 1,5 à 2 mm conduisant à un substrat percé ou troué de forme « annulaire » comme illustré sur la figure 4.

L'épaisseur entre les parois 14 et 18 peut être réduite par la découpe laser de l'ouverture traversante à environ 500 micromètres voire moins si possible.

Le ratio « dimension latérale de l'ouverture traversante (20) » / « épaisseur comprise entre les parois intérieures (18) et les parois extérieures latérales (14) » est peut être réalisé le plus grand possible, par exemple supérieur à 2, 3 ou 4.

La (ou les) paroi(s) intérieure(s) 18 délimitée(s) par l'ouverture traversante peut (peuvent) être réalisée(s) pour être verticale(s) quand la paroi inférieure 12 repose en appui sur une base ou un porte-substrat de réacteur CVD.

Typiquement, l'ouverture 20 comprend au moins deux parois intérieures 18, en regard et parallèles l'une à l'autre conduisant à un substrat percé de forme « annulaire ». Ici comme illustré sur la figure 4, elle comprend deux paires de deux parois intérieures 18 lorsque l'ouverture présente un pourtour rectangulaire, en particulier carré.

Selon un mode de réalisation de l'invention illustré aux figures 1 à 3, les parois intérieures sont orientées perpendiculairement à la ou les parois extérieures supérieures 16, par exemple entre les plans (100) et (010).

Afin d'assurer la résistance mécanique du substrat germe, il est préférable que l'épaisseur entre la ou les parois extérieures latérales 14 et la ou les parois intérieures latérales 18 soit d'au moins 500 µm.

Selon le mode de réalisation représenté sur les figures 1 à 3, la ou les parois extérieures supérieures 16 sont dans le plan (001) ou un plan équivalent. Selon des variantes de l'invention, la ou les parois extérieures supérieures 16 peuvent être comprises dans un plan (113) ou équivalent, ou un plan (111) ou équivalent, ou un plan (110) ou équivalent.

Selon une variante de l'invention, la ou les parois extérieures supérieures 16 peuvent également comprendre un ensemble de plans présentant une désorientation cristallographique de quelques degrés par rapport à l'un des plans (001), (110), (113) et (111).

Les inventeurs ont pu observer que lorsque la ou les parois supérieures extérieures 16 et la ou les parois intérieures latérales 18 forment un angle α légèrement inférieur à 90 °, les dislocations 16A dues à la croissance homoépitaxiale à partir de la ou des parois supérieures extérieures 16 sont déviées vers une direction extérieure s'éloignant de l'ouverture traversante 20, ce qui permet d'obtenir une zone T à faible taux de dislocations de plus grande surface.

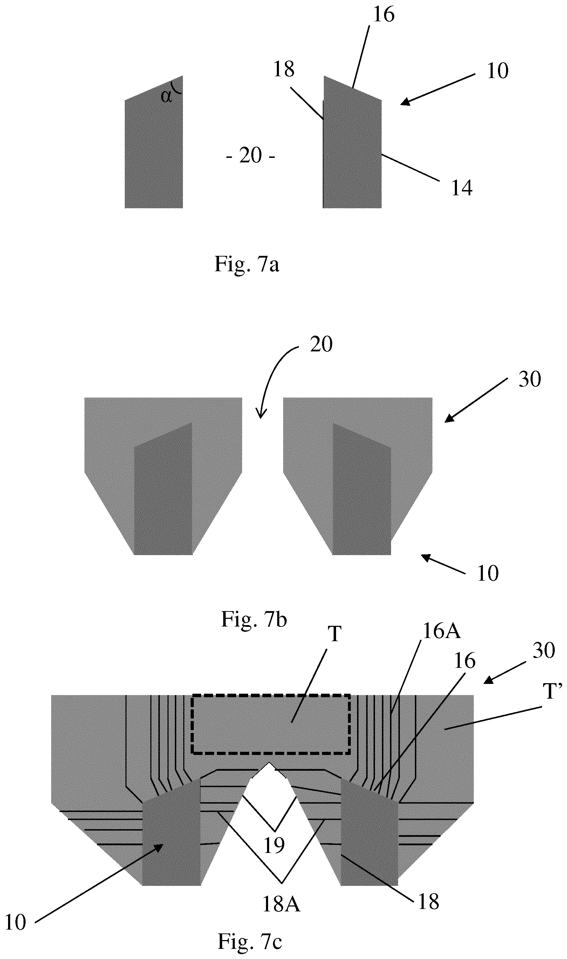

Par exemple pour un angle α inférieur à 90° et supérieur ou égal à 50°, la taille de la zone de monocristal T à faible densité est avantageusement augmentée, comme illustré sur la figure 7.

Par exemple pour un angle α inférieur à 80° et supérieur ou égal à 50°, la taille de la zone de monocristal T à faible densité de dislocations est avantageusement augmentée, comme illustré sur la figure 7.

L'angle inférieur à 80° permet de dévier les dislocations 16A vers l'extérieur sur les figures, permettant d'agrandir la zone T.

L'angle supérieur à 50° permet de ne pas trop fragiliser mécaniquement le substrat germe.

L'invention se rapporte également à un procédé de formation d'un monocristal de diamant comprenant les étapes suivantes :
- on réalise une ouverture traversante dans un substrat germe de diamant monocristallin ayant une densité de dislocations initiale supérieure ou égale à 10⁴ cm-², pour obtenir le substrat germe ajouré,
- on dépose le substrat germe ajouré de diamant monocristallin selon l'invention, ayant une densité de dislocations initiale supérieure ou égale à 10⁴ cm⁻² dans un réacteur à croissance
- on effectue une croissance homoépitaxiale par dépôt chimique en phase vapeur sur l'ensemble des parois du substrat, excepté sur la paroi inférieure 12.

L'utilisation d'un substrat germe selon l'invention dans des conditions de croissance optimisées permet que :
- la croissance homoépitaxiale du diamant soit réalisée normalement sur la ou les parois supérieures extérieures 16,
- la croissance homoépitaxiale du diamant soit réalisée latéralement sur la ou les parois latérales extérieures 14,
- la croissance homoépitaxiale du diamant soit réalisée latéralement sur la ou les parois intérieures 18 formant des zones de croissance latérale dans l'ouverture traversante 20 conduisant à une coalescence du diamant qui croit latéralement à partir de ces parois intérieures, et donc à une disparition progressive de l'ouverture traversante,
Le mode de croissance du diamant permet de définir une zone située au-dessus de l'ouverture traversante présentant une densité de dislocations inférieure d'au moins un à plusieurs ordres de grandeur par rapport à celle du substrat germe de départ.

Avantageusement, la bonne qualité cristalline ne se fait pas au détriment de la pureté du cristal puisqu'il n'est pas nécessaire d'ajouter de larges quantités d'azote pendant la croissance.

Avantageusement, l'ouverture traversante est réalisée sans tenir compte de la localisation des dislocations du substrat germe, sans masquage, ce qui donne un grand intérêt du procédé par un gain de temps et économique.

Les inventeurs ont pu vérifier par photoluminescence que le cristal ne contient qu'une faible quantité d'azote incorporée.

En outre, la révélation des dislocations traversantes par gravure révèle que l'essentiel des dislocations est contenue dans le secteur de croissance situé directement au-dessus des parois extérieures supérieures 16 du substrat germe comme illustré sur les photographies 8a à 8c. Cette gravure est réalisée sur une épaisseur faible, comprise entre 0,1 et 2 micromètres, juste suffisante pour permettre la détection des zones de défauts. La gravure est par exemple une gravure sèche en plasma microonde constitué d'un mélange de gaz tel que H₂ - O₂. (98:2)

A l'opposé, la zone centrale T du monocristal de diamant située au-dessus de l'ouverture traversante du substrat germe contient une densité de 1 à 2 ordres de grandeur plus faible, soit environ 10³ cm⁻².

Une analyse fine en cathodoluminescence permet de mettre en évidence le bénéfice de l'invention (figure 6d).

En imageant la luminescence des excitons libres sous l'effet d'un faisceau électronique de MEB, il est possible de visualiser les dislocations qui apparaissent comme des lignes noires en raison de recombinaisons non-radiatives des excitons sur ces défauts.

L'image en figure 6a montre clairement que les dislocations issues du substrat tendent à se propager préférentiellement selon les directions <001> et <010>, perpendiculairement aux parois supérieures extérieures 16 et aux parois latérales intérieures 18 du substrat germe.

La zone du monocristal de diamant située directement au-dessus des parois extérieures supérieures 16 du corps du substrat germe contient une forte densité de dislocations comme illustré en figure 6c alors que la zone de monocristal de diamant située au-dessus de l'ouverture traversante 20 en est presque exempte comme illustrée en figure 6d.

On note toutefois que la zone de coalescence des fronts issus des différentes faces peut constituer une nouvelle source de défauts comme illustré en figure 6b même si celle-ci semble relativement limitée.

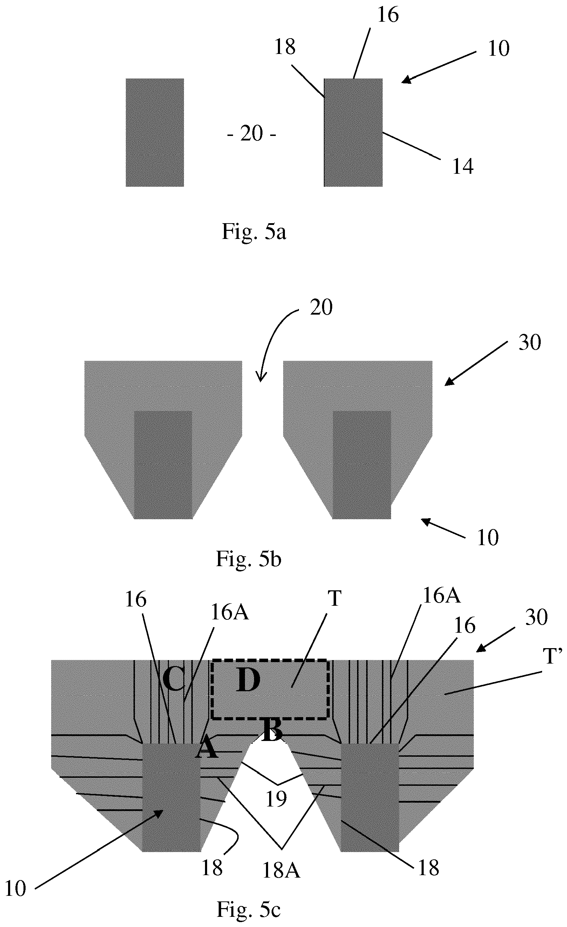

Le procédé selon l'invention peut également comprendre une étape de découpe de la zone de monocristal T obtenue après croissance et coalescence dans ou au-dessus de l'ouverture traversante 20 du substrat germe afin d'en extraire un monocristal contenant une faible densité de dislocations et pouvant à nouveau être utilisé pour une croissance homoépitaxiale. Cette zone est illustrée par un rectangle pointillé sur les figures 5c et 7c.

La croissance du diamant peut être réalisée par la technique de dépôt chimique en phase vapeur assisté par plasma (PACVD).

La technique PACVD est généralement basée sur la création d'un plasma dans une région de basse ou moyenne pression sous un champ électrique provenant de l'application de micro-ondes dans une chambre à cavité résonante.

Parmi tous les réacteurs de PACVD, ceux fonctionnant à des densités de puissance élevées sont préférés pour la croissance de couches de diamant épaisses, étant connus pour fournir une meilleure qualité cristalline, avec des vitesses de croissance raisonnablement élevées, allant jusqu'à quelques dizaines de µm/h.

Ceci est essentiellement lié à une dissociation thermique plus efficace des espèces chimiques dans le plasma qui est essentielle à la croissance du diamant.

Un réacteur PACVD fonctionne typiquement dans une plage de pression de 20 à 500 mbar, ou de manière préférée dans la plage de 100 à 300 mbar.

Les générateurs de micro-ondes utilisés sont généralement à des fréquences de 2,45 GHz ou 915 MHz bien que d'autres fréquences soient parfois utilisées.

La puissance fournie au cours de la croissance est typiquement, pour une fréquence de 2,45 GHz, comprise dans l'intervalle 100 à 10000 W, ou de manière préférée dans la plage de 2000 à 5000 W et pour une fréquence de 915 MHz, dans la plage 5000 à 60000 W, ou de manière davantage préférée dans la plage 20000 à 40000W.

Un mélange d'hydrogène et de méthane, est nécessaire à la synthèse du diamant avec un rapport allant de 99:1 jusqu'à 50:50. Une composition de 90-99 : 10-1 est préférable pour assurer des conditions de fonctionnement stables et une bonne qualité de cristal. Le débit total de gaz introduits dans le réacteur peut varier de 10 à 50000 sccm (standard centimètre cube par minute), de préférence de 100 à 1000 sccm.

Une quantité importante d'autres gaz peut être ajoutée pour améliorer les vitesses de croissance ou la qualité de cristal. Ces gaz peuvent comprendre des gaz rares (Ar, He, Ne ...) dans la gamme de 0-50%, de préférence 0-20%.

L'azote est aussi parfois présent en tant qu'impureté, par exemple plusieurs parties par million, ppm ou ajouté intentionnellement. Cela conduit à accélérer les taux de dépôt et affecte les morphologies de surface.

Un ajout d'azote sous la forme de N₂ peut être utilisé dans la plage de 0 à 100000 ppm, de préférence dans la plage de 0 à 50 ppm.

Un gaz contenant de l'oxygène peut également être ajouté sous la forme d'O₂, CO ou CO₂ dans la gamme 0 à 60%, car l'oxygène atomique attaque fortement les phases non-diamants.

Enfin, des impuretés qui sont bien connues pour modifier la conductivité électrique du diamant peuvent également être ajoutées afin de créer des accepteurs de type p (bore) ou des donneurs de type n (phosphore, arsenic). L'introduction d'un gaz contenant des dopants à une concentration de 0 à 100000 ppm, ou plus généralement dans la gamme de 0 à 10000 ppm peut être réalisée.

Au cours de la croissance, le substrat germe est maintenu à une température comprise entre 600 à 1200 °C, de manière préférée entre 750 à 950 °C.

La température est contrôlée soit par refroidissement du substrat en utilisant une circulation d'eau ou de gaz dans le porte substrat lorsque la température du plasma est très élevée, par exemple sous des densités de puissance élevées, ou dans certains cas par chauffage résistif du substrat lorsque la température du plasma est modérée, par exemple sous faibles densités de puissance.

La croissance du monocristal de diamant sur le substrat germe de l'invention est illustrée sur les figures 5a à 5c.

Une vue d'une coupe verticale d'un substrat germe cubique 10 selon l'invention est représentée en figure 5a avant le dépôt par CVD.

En figure 5b, est représentée une vue en coupe du substrat 10 selon l'invention sur lequel un dépôt d'un monocristal de diamant 30 a commencé sur les parois extérieures supérieures 16, les parois extérieures latérales 14 et les parois intérieures latérales 18.

En figure 5c, est représentée une vue en coupe du substrat 10 selon l'invention lorsque le dépôt de monocristal est terminé. Comme représenté, le monocristal a coalescé au-dessus de l'ouverture traversante 20 du substrat germe.

Les espèces précurseurs produites par dissociation dans le plasma conduisent à une croissance des parois supérieures et intérieures du substrat germe de telle sorte que l'ouverture se referme progressivement (figure 5b). Ainsi les dislocations 18A issues des parois latérales intérieures 18 et les dislocations 16A issues des parois extérieures supérieures 16, qui sont sensiblement perpendiculaires aux surfaces à partir desquelles elles croissent, sont confinées dans le secteur de croissance situé au-dessus du substrat ou dans l'ouverture où elles se terminent sur une surface libre 19.

Les dislocations 18A provenant de deux parois intérieures 18 opposées en regard ne se rencontrent pas grâce à cette surface libre 19, ce qui évite de générer dans la zone T des dislocations qui seraient issues de cette rencontre.

Il en résulte que la zone T contient une densité fortement réduite en dislocations.

La zone T est située verticalement au-dessus de l'ouverture traversante 20, et n'est pas située verticalement au-dessus des parois extérieures supérieures 16 pour la réalisation illustrée sur la figure 5c.

La zone T est située principalement verticalement au-dessus de l'ouverture traversante 20, et en partie seulement verticalement au-dessus des parties des parois extérieures supérieures 16 qui sont les plus proches de l'ouverture traversante 20, pour la réalisation illustrée sur la figure 7c, en conséquence de la déviation des dislocations 16A fonction de l'angle a.

La vitesse de croissance du diamant est souvent supérieure lorsque la croissance s'effectue latéralement plutôt que normalement. Une vitesse latérale environ 2,5 fois plus grande que la vitesse normale a été mesurée. Ainsi la disparition complète d'une ouverture de 2 mm de largeur aura lieu pour une croissance verticale d'environ 400 µm. Il est avantageux d'utiliser des conditions de croissance conduisant à des vitesses latérales élevées de manière à assurer une disparition rapide de l'ouverture. C'est seulement après cette étape que la plaque de diamant CVD à faible densité de dislocation peut en effet être extraite. Par ailleurs plus l'ouverture est grande et plus la zone exempte de dislocations sera étendue.

A noter qu'il est aussi possible de réaliser une zone T' à dislocations réduites à partir de la croissance latérale des parois extérieures latérales 14.

L'invention ne se limite pas aux modes de réalisation décrits, en particulier, d'autres procédés de croissance du diamant par dépôt chimique en vapeur peuvent être utilisés comme par exemple la CVD par filament chaud (HFCVD) ou par plasma DC, ainsi que les procédés à torche plasma, ou de type arc-jet.

De manière plus générale, l'invention n'est pas limitée aux exemples décrits. Il est bien entendu que de nombreuses adaptations aux configurations décrites ci-dessus peuvent être introduites tout en conservant au moins certains des avantages de l'invention.

L'expression « comprenant un » doit être comprise comme synonyme de l'expression « comprenant au moins un », sauf lorsque le contraire est spécifié.

## Revendications

1. Substrat germe (10) de diamant monocristallin, pour la croissance homoépitaxiale de diamant par dépôt chimique en phase vapeur,
présentant un corps constitué :
- d'une paroi inférieure (12) servant d'appui sur la base ou porte-substrat d'un réacteur, et
- d'une ou de plusieurs parois extérieures latérales (14), et d'une ou de plusieurs parois extérieures supérieures (16) destinées à permettre une croissance homoépitaxiale par dépôt chimique en phase vapeur,
**caractérisé en ce que** l'intérieur du corps est ajouré par une ouverture traversante (20) réalisée par découpe laser, destinée à évider le corps et s'étendant de la ou des parois extérieures supérieures (16) à la paroi inférieure (12),
cette ouverture traversante (20) étant délimitée par une ou plusieurs parois intérieures (18) destinées à permettre une croissance homoépitaxiale latérale par dépôt chimique en phase vapeur,
l'ouverture traversante (20) présentant une hauteur égale à la hauteur du corps, et des dimensions latérales dans le plan perpendiculaire aux parois intérieures et donc à la hauteur, supérieures à 0,5 mm chacune, l'ouverture traversante étant située dans le corps sans tenir compte de la localisation des dislocations du substrat germe.

2. Substrat germe de diamant monocristallin selon la revendication 1, **caractérisé en ce que** l'intérieur du corps est ajouré par une seule ouverture traversante.

3. Substrat germe de diamant monocristallin selon la revendication 1 à 2, **caractérisé en ce que** l'ouverture traversante (20) présente des dimensions latérales d'un à plusieurs mm chacune.

4. Substrat germe de diamant monocristallin selon l'une des revendications 1 à 3, **caractérisé en ce que** l'ouverture traversante (20) présente au moins deux parois intérieures (18), en regard, parallèles l'une à l'autre.

5. Substrat germe de diamant monocristallin selon l'une des revendications 1 à 4, **caractérisé en ce que** l'ouverture traversante (20) présente un pourtour rectangulaire, et deux paires de deux parois intérieures, en regard, parallèles l'une à l'autre, formant ce pourtour rectangulaire qui présente une longueur et une largeur d'un à plusieurs mm chacune.

6. Substrat germe de diamant monocristallin selon l'une des revendications 1 à 5, **caractérisé en ce que** l'ouverture traversante a des dimensions latérales plus grandes que la dimension d'une épaisseur comprise entre les parois intérieures (18) et les parois extérieures latérales (14).

7. Substrat germe de diamant monocristallin selon l'une des revendications 1 à 6, **caractérisé en ce que** le ratio « dimension latérale de l'ouverture traversante (20) » / «épaisseur comprise entre les parois intérieures (18) et les parois extérieures latérales (14) » est supérieur à 3.

8. Substrat germe de diamant monocristallin selon l'une des revendications 1 à 7, **caractérisé en ce qu'**une hauteur de l'ouverture traversante est supérieure ou égale à 0, 5mm.

9. Substrat germe de diamant monocristallin selon l'une des revendications 1 à 8, **caractérisé en ce que** le corps est du diamant naturel et/ou est réalisé par un procédé HPHT.

10. Substrat germe de diamant monocristallin selon l'une des revendications 1 à 9, **caractérisé en ce que** l'ouverture traversante (20) est située au centre du corps.

11. Substrat germe de diamant monocristallin selon l'une des revendications 1 à 10, **caractérisé en ce que** la ou les parois supérieures extérieures (16) sont un plan (001) ou équivalent.

12. Substrat germe de diamant monocristallin selon l'une des revendications 1 à 11, **caractérisé en ce que** les parois intérieures (18) sont orientées entre les plans (100) et (010).

13. Substrat germe de diamant monocristallin selon l'une des revendications 1 à 12, **caractérisé en ce que** le corps est un parallélépipède rectangle, avantageusement un parallélépipède rectangle à base carrée.

14. Procédé de formation d'un monocristal de diamant comprenant les étapes suivantes :
- on réalise une ouverture traversante par découpe laser et sans l'utilisation de masque dans un substrat germe de diamant monocristallin ayant une densité de dislocations initiale supérieure ou égale à 10⁴ cm-2, de façon à évider le substrat germe, pour obtenir le substrat germe ajouré selon l'une quelconque des revendications 1 à 13, l'ouverture traversante (20) présentant une hauteur égale à la hauteur du corps, et des dimensions latérales dans le plan perpendiculaire aux parois intérieures et donc à la hauteur, supérieures à 0,5 mm chacune,
- on dépose le substrat germe ajouré dans un réacteur de croissance,
- on effectue une croissance homoépitaxiale par dépôt chimique en phase vapeur sur l'ensemble des parois extérieures supérieures (16), des parois extérieures latérales (14) et des parois intérieures (18) du substrat de sorte que :
la croissance homoépitaxiale du diamant soit réalisée normalement sur la ou les parois supérieures extérieures (16),
la croissance homoépitaxiale du diamant soit réalisée latéralement sur la ou les parois latérales extérieures (14),
la croissance homoépitaxiale du diamant soit réalisée latéralement sur la ou les parois intérieures (18) formant des zones de croissance latérale dans l'ouverture traversante (20) conduisant à une coalescence du diamant qui croit latéralement à partir de ces parois intérieures (18), et donc à une disparition progressive de l'ouverture traversante (20)
définissant ainsi une zone T située au-dessus de l'ouverture traversante (20) présentant une densité de dislocations inférieure d'au moins un à plusieurs ordres de grandeur par rapport à celle du substrat germe de départ,
les dislocations (18A) issues des parois latérales intérieures (18) étant confinées dans l'ouverture traversante où elles se terminent sur une surface libre (19),
les dislocations (16A) issues des parois extérieures supérieures (16) étant confinées dans le secteur de croissance situé au-dessus des parois extérieures supérieures (16) du substrat,
- on découpe la zone de monocristal T au-dessus de l'ouverture traversante (20) contenant une densité de dislocations inférieure ou égale à 10³ cm⁻² et pouvant à nouveau être utilisée pour une croissance homoépitaxiale par dépôt chimique en phase vapeur.

15. Procédé selon la revendication 14, dans lequel on réalise une seule ouverture traversante.

## Patentansprüche

1. Keimsubstrat (10) aus monokristallinem Diamant, für ein homoepitaxiales Wachstum von Diamant durch chemische Dampfphasenabscheidung, welches einen Körper aufweist, bestehend aus:
- einer unteren Wand (12), die als Auflage auf der Basis oder Substratträger eines Reaktors dient, und
- einer oder mehreren seitlichen Außenwänden (14), und einer oder mehreren oberen Außenwänden (16), die dazu bestimmt sind, ein homoepitaxiales Wachstum durch chemische Dampfphasenabscheidung zu gestatten,
**dadurch gekennzeichnet, dass** das Innere des Körpers durch eine Durchgangsöffnung (20) durchbrochen ist, die durch Laserschneiden hergestellt wurde, die dazu bestimmt ist, den Körper auszuhöhlen, und die sich von der oberen Außenwand oder den oberen Außenwänden (16) zur unteren Wand (12) erstreckt,
wobei diese Durchgangsöffnung (20) von einer oder mehreren Innenwänden (18) begrenzt wird, die dazu bestimmt sind, ein seitliches homoepitaxiales Wachstum durch chemische Dampfphasenabscheidung zu gestatten,
wobei die Durchgangsöffnung (20) eine Höhe, die gleich der Höhe des Körpers ist, und seitliche Abmessungen in der Ebene rechtwinklig zu den Innenwänden und daher zur Höhe von jeweils mehr als 0,5 mm aufweist, wobei die Durchgangsöffnung in dem Körper angeordnet ist, ohne die Anordnung von Versetzungen des Keimsubstrats zu berücksichtigen.

2. Keimsubstrat aus monokristallinem Diamant nach Anspruch 1, **dadurch gekennzeichnet, dass** das Innere des Körpers durch eine einzige Durchgangsöffnung durchbrochen ist.

3. Keimsubstrat aus monokristallinem Diamant nach Anspruch 1 bis 2, **dadurch gekennzeichnet, dass** die Durchgangsöffnung (20) seitliche Abmessungen von jeweils einem bis mehreren mm aufweist.

4. Keimsubstrat aus monokristallinem Diamant nach einem der Ansprüche 1 bis 3, **dadurch gekennzeichnet, dass** die Durchgangsöffnung (20) mindestens zwei gegenüberliegende, zueinander parallele Innenwände (18) aufweist.

5. Keimsubstrat aus monokristallinem Diamant nach einem der Ansprüche 1 bis 4, **dadurch gekennzeichnet, dass** die Durchgangsöffnung (20) einen rechteckigen Umfang und zwei Paare von gegenüberliegenden, zueinander parallelen Innenwänden aufweist, die diesen rechteckigen Umfang bilden, der eine Länge und eine Breite von jeweils einem bis mehreren mm aufweist.

6. Keimsubstrat aus monokristallinem Diamant nach einem der Ansprüche 1 bis 5, **dadurch gekennzeichnet, dass** die Durchgangsöffnung größere seitliche Abmessungen aufweist als die Abmessung einer Dicke zwischen den Innenwänden (18) und den seitlichen Außenwänden (14).

7. Keimsubstrat aus monokristallinem Diamant nach einem der Ansprüche 1 bis 6, **dadurch gekennzeichnet, dass** das Verhältnis "seitliche Abmessung der Durchgangsöffnung (20)" / "Dicke zwischen den Innenwänden (18) und den seitlichen Außenwänden (14)" größer als 3 ist.

8. Keimsubstrat aus monokristallinem Diamant nach einem der Ansprüche 1 bis 7, **dadurch gekennzeichnet, dass** eine Höhe der Durchgangsöffnung größer oder gleich 0,5 mm ist.

9. Keimsubstrat aus monokristallinem Diamant nach einem der Ansprüche 1 bis 8, **dadurch gekennzeichnet, dass** der Körper aus natürlichem Diamant ist und/oder durch ein HPHT-Verfahren hergestellt wird.

10. Keimsubstrat aus monokristallinem Diamant nach einem der Ansprüche 1 bis 9, **dadurch gekennzeichnet, dass** die Durchgangsöffnung (20) im Zentrum des Körpers angeordnet ist.

11. Keimsubstrat aus monokristallinem Diamant nach einem der Ansprüche 1 bis 10, **dadurch gekennzeichnet, dass** die obere Außenwand oder die oberen Außenwände (16) eine (001) Ebene oder ein Äquivalent sind.

12. Keimsubstrat aus monokristallinem Diamant nach einem der Ansprüche 1 bis 11, **dadurch gekennzeichnet, dass** die Innenwände (18) zwischen den Ebenen (100) und (010) ausgerichtet sind.

13. Keimsubstrat aus monokristallinem Diamant nach einem der Ansprüche 1 bis 12, **dadurch gekennzeichnet, dass** der Körper ein rechteckiges Parallelepiped ist, vorteilhaft ein rechteckiges Parallelepiped mit quadratischer Basis.

14. Verfahren zur Bildung eines Diamanteinkristalls, umfassend die folgenden Schritte:
- eine Durchgangsöffnung wird durch Laserschneiden und ohne Verwendung einer Maske in einem Keimsubstrat aus monokristallinem Diamant mit einer anfänglichen Dichte von Versetzungen größer oder gleich 10⁴ cm⁻² hergestellt, um das Keimsubstrat auszuhöhlen, um das durchbrochene Keimsubstrat nach einem der Ansprüche 1 bis 13 zu erhalten, wobei die Durchgangsöffnung (20) eine Höhe gleich der Höhe des Körpers und seitliche Abmessungen in der Ebene rechtwinklig zu den Innenwänden und daher zur Höhe von jeweils größer als 0,5 mm aufweist,
- das durchbrochene Keimsubstrat wird in einen Wachstumsreaktor gegeben,
- ein homoepitaxiales Wachstum durch chemische Dampfphasenabscheidung auf der Gesamtheit der oberen Außenwände (16), der seitlichen Außenwände (14) und der Innenwände (18) des Substrats wird derart bewirkt, dass:
das homoepitaxiale Wachstum des Diamanten normal zu der oberen Außenwand oder den oberen Außenwänden (16) durchgeführt wird,
das homoepitaxiale Wachstum des Diamanten seitlich auf der seitlichen Außenwand oder den seitlichen Außenwänden (14) durchgeführt wird,
das homoepitaxiale Wachstum des Diamanten seitlich auf der Innenwand oder den Innenwänden (18) durchgeführt wird, die seitliche Wachstumszonen in der Durchgangsöffnung (20) bilden, was zu einer Koaleszenz des Diamanten, der seitlich auf diesen Innenwänden (18) wächst, und daher zu einem progressiven Verschwinden der Durchgangsöffnung (20) führt,
wobei so eine Zone T definiert wird, welche über der Durchgangsöffnung (20) angeordnet ist und eine Dichte von Versetzungen aufweist, die mindestens kleiner ist als eine oder mehrere Größenordnungen in Bezug auf jene des Ausgangskeimsubstrats,
wobei die Versetzungen (18A) in den seitlichen Innenwänden (18) in der Durchgangsöffnung begrenzt sind, wo sie an einer freien Fläche (19) enden,
wobei die Versetzungen (16A) in den oberen Außenwänden (16) in dem Wachstumssektor begrenzt sind, der über den oberen Außenwänden (16) des Substrats angeordnet ist,
- die monokristalline Zone T über der Durchgangsöffnung (20) wird geschnitten, die eine Dichte von Versetzungen kleiner oder gleich 10³ cm⁻² aufweist und erneut für ein homoepitaxiales Wachstum durch chemische Dampfphasenabscheidung verwendet werden kann.

15. Verfahren nach Anspruch 14, wobei eine einzige Durchgangsöffnung hergestellt wird.

## Claims

1. Single-crystal diamond seed substrate (10), for homoepitaxial diamond growth by chemical vapour deposition,
having a body consisting:
- of a lower wall (12) serving as support on the base or substrate holder of a reactor, and
- of one or more lateral outer walls (14), and of one or more upper outer walls (16) intended to enable a homoepitaxial growth by chemical vapour deposition, **characterized in that** the interior of the body is perforated by a through-opening (20) produced by laser cutting, intended to hollow out the body and extending from the upper outer wall(s) (16) to the lower wall (12), this through-opening (20) being delimited by one or more inner walls (18) intended to enable a lateral homoepitaxial growth by chemical vapour deposition,
the through-opening (20) having a height equal to the height of the body, and lateral dimensions in the plane perpendicular to the inner walls and therefore to the height, of greater than 0.5 mm each, the through-opening being located in the body without taking into account the location of the dislocations of the seed substrate.

2. Single-crystal diamond seed substrate according to Claim 1, **characterized in that** the interior of the body is perforated by a single through-opening.

3. Single-crystal diamond seed substrate according to Claim 1 or 2, **characterized in that** the through-opening (20) has lateral dimensions of from one to several mm each.

4. Single-crystal diamond seed substrate according to one of Claims 1 to 3, **characterized in that** the through-opening (20) has at least two opposite inner walls (18) that are parallel to one another.

5. Single-crystal diamond seed substrate according to one of Claims 1 to 4, **characterized in that** the through-opening (20) has a rectangular perimeter, and two pairs of two opposite inner walls that are parallel to one another, forming this rectangular perimeter which has a length and a width of from one to several mm each.

6. Single-crystal diamond seed substrate according to one of Claims 1 to 5, **characterized in that** the through-opening has lateral dimensions larger than the dimension of a thickness between the inner walls (18) and the lateral outer walls (14).

7. Single-crystal diamond seed substrate according to one of Claims 1 to 6, **characterized in that** the "lateral dimension of the through-opening (20)"/"thickness between the inner walls (18) and the lateral outer walls (14)" ratio is greater than 3.

8. Single-crystal diamond seed substrate according to one of Claims 1 to 7, **characterized in that** a height of the through-opening is greater than or equal to 0.5 mm.

9. Single-crystal diamond seed substrate according to one of Claims 1 to 8, **characterized in that** the body is of natural diamond and/or is produced by a HPHT process.

10. Single-crystal diamond seed substrate according to one of Claims 1 to 9, **characterized in that** the through-opening (20) is located at the centre of the body.

11. Single-crystal diamond seed substrate according to one of Claims 1 to 10, **characterized in that** the outer upper wall(s) (16) are a (001) plane or equivalent.

12. Single-crystal diamond seed substrate according to one of Claims 1 to 11, **characterized in that** the inner walls (18) are oriented between the (100) and (010) planes.

13. Single-crystal diamond seed substrate according to one of Claims 1 to 12, **characterized in that** the body is a rectangular parallelepiped, advantageously a square-based rectangular parallelepiped.

14. Process for forming a diamond single-crystal comprising the following steps:
- making a through-opening by laser cutting and without the use of a mask in a single-crystal diamond seed substrate having an initial dislocation density of greater than or equal to 10⁴ cm⁻², so as to hollow out the seed substrate, to obtain the perforated seed substrate according to any one of Claims 1 to 13, the through-opening (20) having a height equal to the height of the body, and lateral dimensions in the plane perpendicular to the inner walls and therefore to the height, or greater than 0.5 mm each,
- depositing the perforated seed substrate in a growth reactor,
- carrying out a homoepitaxial growth by chemical vapour deposition on all of the upper outer walls (16), lateral outer walls (14) and inner walls (18) of the substrate so that:
the homoepitaxial growth of the diamond is carried out at right angles on the outer upper wall(s) (16),
the homoepitaxial growth of the diamond is carried out laterally on the outer lateral wall(s) (14),
the homoepitaxial growth of the diamond is carried out laterally on the inner wall(s) (18) forming zones of lateral growth in the through-opening (20) leading to a coalescence of the diamond which grows laterally from these inner walls (18), and therefore to a gradual disappearance of the through-opening (20)
thus defining a T zone located above the through-opening (20) having a dislocation density that is lower by at least one or several orders of magnitude relative to that of the initial seed substrate,
the dislocations (18A) originating from the inner lateral walls (18) being confined in the through-opening where they terminate on a free surface (19), the dislocations (16A) originating from the upper outer walls (16) being configured in the growth sector located above the upper outer walls (16) of the substrate,
- cutting the single-crystal T zone above the through-opening (20) containing a dislocation density less than or equal to 10³ cm⁻² and that may again be used for a homoepitaxial growth by chemical vapour deposition.

15. Process according to Claim 14, in which a single through-opening is made.
